# EUROPEAN PATENT APPLICATION

(11) **EP 4 664 265 A1**
(43) Date of publication of application: **17.12.2025**
(21) Application number: 25180142.9
(22) Date of filing: 02.06.2025
(51) Int. Cl.: G06F 3/06, G06F 12/02, G11C 16/10, G11C 16/08, G11C 16/16

(54) **STORAGE DEVICE AND OPERATING METHOD THEREOF FOR REDUCING DIFFERENCE IN PROGRAM TIME BETWEEN WORD LINES**

(30) Priority: 10.06.2024 KR 20240075289; 17.10.2024 KR 20240142309
(71) Applicant: Samsung Electronics Co., Ltd., Suwon-si, Gyeonggi-do 16677 (KR)
(72) Inventor: KIM, Haknyun, 16677 Suwon-si (KR); KO, Minseok, 16677 Suwon-si (KR); JUNG, Minwook, 16677 Suwon-si (KR)
(74) Representative: Marks & Clerk LLP

(57) **Abstract**

A storage device includes a plurality of non-volatile memory devices and a storage controller configured to generate program commands and first addresses corresponding to a plurality of word lines included in a first super block based on a sequential write request from a host, determine whether to allocate at least one sub-memory block included in a second super block based on data of a word line table which indicate word lines having a relatively small program time and the first addresses, and generate at least one erase command and at least one second address corresponding to the allocated at least one sub-memory block for performing an erase operation.

## Description

### TECHNICAL FIELD

The disclosure relates to an electronic device. More particularly, the invention relates to a storage system and an operating method of a storage system. Generally, embodiments may reduce the difference in program time between word lines and/or reduce peak power consumption due to erase operations.

### BACKGROUND

A semiconductor memory device may include a volatile memory device and a non-volatile memory device. The volatile memory device loses stored data when power supply is cut off. On the other hand, the non-volatile memory device may preserve stored data even when power supply is cut off. Because the non-volatile memory device such as a flash memory device is advantageous in respect of integration density, the non-volatile memory device is well-suited for a storage device which requires a large capacity of the non-volatile memory device. For increasing capacity of the non-volatile memory device, the process technology for non-volatile memory device becomes finer, and the number of memory blocks in the non-volatile memory device increases and the size of each memory block increases. As the size of a memory block increases, the number of word lines within each memory block also increases, and may cause a difference in program time between word lines. The difference in program time between word lines may deteriorate data reliability of the non-volatile memory device.

### SUMMARY

The present invention is defined by the independent claims. Preferred embodiments are defined by the dependent claims.

According to an aspect of the present invention, there is provided a storage device that includes a plurality of non-volatile memory devices, each non-volatile memory device including a plurality of memory blocks, and a storage controller configured to provide a command and an address to a target non-volatile memory device of the plurality of non-volatile memory devices, wherein the storage controller is configured to receive a write request from a host, generate a program command and a first address based on the write request from the host, wherein the first address corresponds to a target word line of a first target non-volatile memory device, determine, based on a word line table and the target word line of the first address, whether to allocate a first target memory block of a second target non-volatile memory device regardless of a request from the host, wherein the word line table comprises first data indicating a first word line, wherein a program time required for programming the first word line is less than a reference program time required for programming each word line of the plurality of memory blocks; and upon determining to allocate the first target memory block, generate an erase command and a second address, wherein the second address corresponds to the first target memory block.

There may further be provided the storage device, wherein the storage controller is further configured to: schedule the program command and the first address; schedule the erase command and the second address; and output the program command and the first address and the erase command and the second address, respectively in a scheduled order.

There may further be provided the storage device wherein, when the erase operation for the first target memory block is completed, the storage controller is further configured to generate an operation command and the second address based on the request from the host.

There may further be provided the storage device, wherein the storage controller is further configured to: allocate the first target memory block for performing the erase operation on the first target memory block when the target word line is same as the first word line; and generate an operation command and a third address in response to the request from the host when the target word line is different from the first word line, wherein the third address corresponds to a second target memory block included in the second target non-volatile memory device.

There may further be provided the storage device, wherein the word line table further comprises second data indicating a second word line, wherein a program time required for programming the second word line is greater than the reference program time, and wherein the storage controller is further configured to: hold outputting the operation command and the third address when the target word line is different from the first word line and same as the second word line; and sequentially output the operation command and the third address and the program command and the first address in a scheduled order when the target word line is different from each of the first word line and the second word line.

There may further be provided the storage device, wherein the storage controller is further configured to: measure a plurality of program times for a plurality of word lines of the plurality of memory blocks; set an average value of the plurality of program times as the reference program time; and store data respectively indicating word lines in the word line table, wherein program times of each of the word lines are less than the reference program time set as the average value.

There may further be provided the storage device, wherein the storage controller is further configured to: generate program commands and first addresses corresponding to a plurality of word lines included in the first target non-volatile memory device based on a sequential write request from the host; and upon each time detecting that each of target word lines corresponding to the first addresses corresponds the first word line, allocate memory blocks included in the second target non-volatile memory device one by one.

There may further be provided the storage device, wherein the plurality of non-volatile memory devices comprise: a plurality of first non-volatile memory devices comprising a first super block; and a plurality of second non-volatile memory devices including a second super block, wherein the first super block and the second super block operate in an interleaving manner, a nd wherein the first target non-volatile memory device comprises the plurality of first non-volatile memory devices, and the second target non-volatile memory device comprises the plurality of second non-volatile memory devices.

There may further be provided the storage device, wherein the storage controller controls at least one non-volatile memory device among the plurality of non-volatile memory devices to store the word line table.

According to another aspect of the present invention, there is provided an operating method of a storage device, wherein the method includes generating a program command and a first address based on a write request from a host, wherein the first address corresponds to a target word line included in a first super block, determining, based on a word line table and the target word line of the first address, whether to allocate a first target memory block included in a second super block, wherein the word line table comprises data indicating word lines, wherein program times of each of the word lines are less than a reference program time, generating a second address corresponding to the first target memory block and an erase command, and, scheduling the program command and the first address and the erase command the second address in a scheduled order, and wherein the first super block and the second super block operate in an interleaving manner.

There may further be provided the operating method, wherein the determining whether to allocate the first target memory block comprises: determining whether the data of the word line table indicate the target word line; upon determining that the data of the word line table indicate the target word line, allocating the first target memory block; and upon determining that the data of the word line table are not indicating the target word line, allocating a second target memory block included in the second super block in response to a request from the host.

There may further be provided the operating method, further comprising outputting the first address and the program command and the second address and the erase command in a scheduled order.

There may further be provided the operating method, wherein a program operation according to the program command and an erase operation according to the erase command are overlapped at least partially.

There may further be provided the operating method, wherein the operating method further comprises updating the word line table, in response to an update request from the host or while performing a background operation.

There may further be provided the operating method, wherein the updating of the word line table comprises: measuring a plurality of program times of a plurality of word lines; setting an average value of the plurality of program times as the reference program time; and updating data of the word line table by storing data respectively indicating word lines in the word line table, wherein program times of each of the word lines are less than the reference program time set as the average value.

According to an embodiment, a storage device includes a plurality of first non-volatile memory devices comprising a first super block, a plurality of second non-volatile memory devices comprising a second super block, wherein the first super block and the second super block operate in an interleaving manner, and a storage controller configured to provide a command and an address to the plurality of first non-volatile memory devices and the plurality of second non-volatile memory devices, wherein the storage controller is further configured to, based on a sequential write request from a host, generate first addresses and program commands to sequentially perform program operations on the first super block, determine, based on data of a word line table and the first addresses of target word lines, whether to allocate at least one first target sub-memory block included in the second super block independently of a request from the host, wherein the word line table includes data indicating first word lines, wherein program times required for programming each of the first word lines are less than a reference program time required for programming each word line of the plurality of sub-memory blocks included in the first super block and the second super block, generate, when the at least one first target sub-memory block is allocated for an erase operation, at least one erase command and at least one second address corresponding to the allocated at least one first target sub-memory block.

Regarding advantages, embodiments provide a storage device and an operating method thereof, which may be for providing consistency in throughput, latency and/or distributing erase operations for each chip or die.

According to embodiments, device performance may be improved by providing consistency in the device throughput and/or latency.

Additionally or alternatively, in embodiments, by reducing long latency of program operations that require a relatively long program time, the device reliability may be improved or guaranteed.

Further additionally or alternatively, in embodiments, by distributing the erase operation across chips or dies, the peak power consumption during the erase operation may be reduced, thereby reducing overall power consumption.

### BRIEF DESCRIPTION OF THE DRAWINGS

Embodiments will be more clearly understood from the following detailed description taken in conjunction with the accompanying drawings in which:
FIG. 1 is a block diagram of a memory system according to an embodiment;
FIG. 2 is a block diagram of a non-volatile memory device according to an embodiment;
FIG. 3 is a circuit diagram of a memory block according to an embodiment;
FIG. 4 is a block diagram of a plurality of super blocks according to an embodiment;
FIG. 5 is a graph illustrating program times for word lines according to an embodiment;
FIG. 6 is a diagram illustrating an example of a word line table according to an embodiment;
FIG. 7 is a flowchart of an operation of generating a word line table according to an embodiment;
FIG. 8 is a flowchart of an operation of a storage device according to embodiments;
FIGS. 9A, 9B, and 9C are diagrams illustrating a sequential write operation performed on one super block and an erase operation performed on a sub-memory block of another super block;
FIG. 10 is a diagram illustrating a word line table according to an embodiment;
FIG. 11 is a flowchart of an operation of a storage device according to embodiments;
FIG. 12 is a flowchart of an operating method of a storage device according to an embodiment;
FIG. 13 is a block diagram of a host-storage system according to an embodiment; and
FIG. 14 is a diagram of a data center to which a memory device is applied.

### DETAILED DESCRIPTION OF THE EMBODIMENTS

Hereinafter, embodiments are described in detail with reference to the accompanying drawings.

The expressions "first," "second," and "third," used herein, may indicate various different components regardless of order and/or importance, and may be used to distinguish one component from another but not to limit the components. For example, a first user device and a second user device may represent different user devices regardless of order or importance thereof. A first component may be referred to as a second component, and the second component may be referred to as the first component in different embodiments, without departing from the scope of the invention as defined by the claims.

It is further noted that any reference herein to a program time 'required' by a word line generally means a preferred minimum time for programming using that word line. Such a preferred minimum time may be predetermined, for example based on measurements that may involve that word line. Preferably, i.e., optionally, the 'required' program time of any particular word line is determined or expected to substantially (e.g. fully) guarantee programming success using that word line.

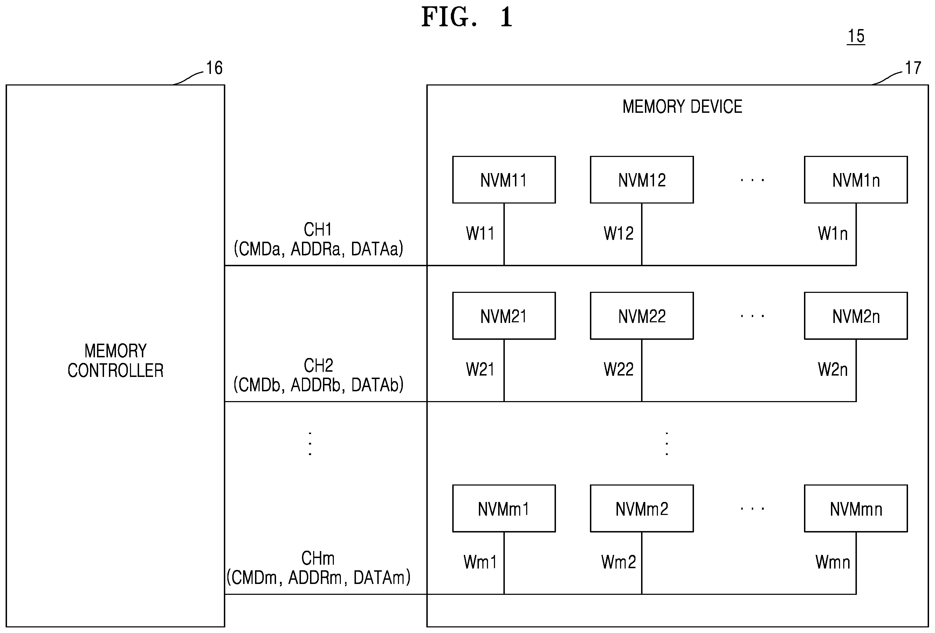

FIG. 1 is a block diagram of a memory system 15, according to an embodiment. It is noted that the terms memory device, memory system, storage device and storage system are generally interchangeable throughout this disclosure.

Referring to FIG. 1, the memory system 15 includes a memory device 17 and a memory controller 16. The memory system 15 may support a plurality of channels. The plurality of channels may include first to mth channels CH1 to CHm, where m is natural number greater than two. Each channel of the plurality of channels may include a plurality of ways. The plurality of ways included in each channel may include first to nth ways, in which each non-volatile memory device is connected to corresponding channel through corresponding way of the first to nth ways, where n is natural number greater than two. The memory device 17 may be connected to the memory controller 16 through the plurality of channels. The memory system 15 may be a storage device such as a solid-state drive (SSD).

The memory device 17 includes a plurality of non-volatile memory devices. The plurality of non-volatile memory devices includes first to mnth non-volatile memory devices NVM11 to NVMmn. Each of the plurality of non-volatile memory devices may be connected to one of the plurality of channels through corresponding way. For example, the non-volatile memory devices NVM11 to NVM1n may be connected to the first channel CH1 through ways W11 to W1n, non-volatile memory devices NVM21 to NVM2n may be connected to the second channel CH2 through ways W21 to W2n, ... , and non-volatile memory devices NVMm1 to NVMmn may be connected to the m-th channel CHm through ways Wm1 to Wmn. Each of the plurality of non-volatile memory devices may receive separate instruction from the memory controller 16 and may operate independently in accordance with the instruction. Each of the plurality of non-volatile memory devices may be implemented in a single chip or in a single die. However, the inventive concept is not limited thereto. Each of the plurality of non-volatile memory devices may include multiple dies.

The memory controller 16 may be also referred to as a storage controller. The memory controller 16 may control the overall operation of the memory device 17. The memory controller 16 may transmit and receive signals to and from the memory device 17 through the plurality of channels. For example, the memory controller 16 may transmit a command, an address, and data to the memory device 17 for a write operation of the memory device 17. The memory controller 16 may transmit a command, an address and receive data from the memory device 17 during a read operation of the memory device 17. The command may be one of CMDa to CMDm depending on the channel through which the memory controller 16 transmits the command. The address may be one of ADDRa to ADDRm depending on the channel through which the memory controller 16 transmits the address. Likewise, the data may be one of DATAa to DATAm depending on the channel through which the memory controller 16 and the memory device 17 transmits and receive the data. For example, the memory controller 16 may transmit 2 or more commands, addresses, and data to the memory device 17 for a write operation of the memory device 17. For example, the memory controller 16 may transmit 2 or more commands and addresses to the memory device 17 for a read operation of the memory device 17.

The memory controller 16 may select a non-volatile memory device among the plurality of non-volatile memory devices through corresponding channel to which the non-volatile memory device is connected and transmit and receive signals to and from the selected non-volatile memory device. The selected non-volatile memory device may be referred to as a target non-volatile memory device. The memory controller 16 provides a command and an address to the target non-volatile memory device. For example, the memory controller 16 may select the non-volatile memory device NVM11 from among the non-volatile memory devices NVM11 to NVM1n connected to the first channel CH1. The memory controller 16 may transmit the command CMDa, the address ADDRa, and the data DATAa to the selected non-volatile memory device NVM11 for a write operation of the selected volatile memory device NVM11 or the memory controller 16 may transmit the command CMDa, the address ADDRa, and receive the data DATAa from the selected non-volatile memory device NVM11 during a read operation of the selected non-volatile memory device NVM11 through the first channel CH1.

The memory controller 16 may access in parallel the non-volatile memory devices connected to different channels. For example, the memory controller 16 may transmit the command CMDb to a non-volatile memory device connected to the second channel CH2 for a read operation while transmitting the command CMDa to a non-volatile memory device connected to the first channel CH1 for a read operation and the memory controller 16 may receive the data DATAb from the non-volatile memory device connected to the second channel CH2 while receiving the data DATAa from the non-volatile memory device connected to the first channel CH1. Because the memory controller 16 may transmit command and address signals and exchange data in parallel with the non-volatile memory devices connected to different channels in an interleaving manner, the performance of the memory system 15 may be enhanced. When the memory device 17 operates in the interleaving manner, the non-volatile memory devices selected across the plurality of channels may operate in parallel. For example, the memory controller 16 may transmit multiple commands and addresses in parallel to the non-volatile memory devices connected to different channels, and each of the non-volatile memory devices that receive the command, address and/or data may operate independently based on the received command, address and/or data. The operating periods of the non-volatile memory devices may be overlapped at least partially.

The memory controller 16 may control each of the plurality of non-volatile memory devices for write or read operation. For example, the memory controller 16 may provide the non-volatile memory device NVM11 connected to the first channel CH1 with data DATAa, command CMDa, and the address ADDRa through the first channel CH1 for programming the DATAa into the non-volatile memory device NVM11. For example, the memory controller 16 may provide the non-volatile memory device NVM21 connected to the second channel CH2 with the command CMDb, and the address ADDRb through the second channel CH2 for reading out the data DATAb from the non-volatile memory device NVM21.

Although FIG. 1 illustrates that the memory device 17 communicates with the memory controller 16 through m number of channels and the memory device 17 includes n number of non-volatile memory devices for each channel, the number of channels and the number of non-volatile memory devices connected to one channel may not be limited thereto.

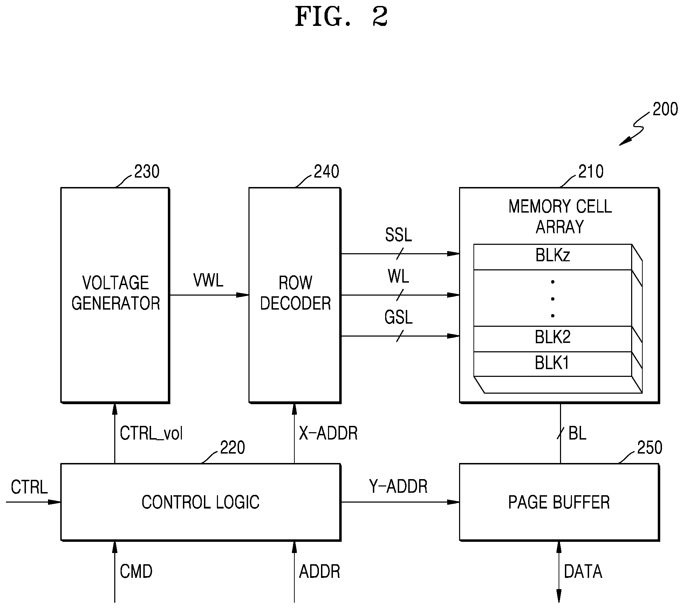

FIG. 2 is a block diagram of a non-volatile memory device 200 according to an embodiment.

Referring to FIG. 2, the non-volatile memory device 200 may correspond to one of the first to mnth non-volatile memory devices NVM11 to NVMmn in FIG. 1. The non-volatile memory device 200 may include a memory cell array 210, control logic 220, a voltage generator 230, a row decoder 240, and a page buffer circuit 250. The non-volatile memory device 200 may further include a data input/output circuit or an input/output interface.

The memory cell array 210 includes a plurality of memory cells, in which the plurality of memory cells are connected to word lines WL, string selection lines SSL, ground selection lines GSL, and bit lines BL. More particularly, the memory cell array 210 may be connected to the row decoder 240 through the word lines WL, the string selection lines SSL, and the ground selection lines GSL, and may be connected to the page buffer circuit 250 through the bit lines BL.

The memory cell array 210 includes a plurality of memory blocks. The plurality of memory blocks include first to zth memory blocks BLK1 to BLKz. Each of the plurality of memory blocks may have a three-dimensional structure, in which memory cells are stacked vertically. Each of the plurality of memory blocks may include one or more memory stacks extending from a surface of a substrate in a vertical direction. Each memory block includes a plurality of NAND flash memory cell strings extending in vertical direction (e.g. a third direction). Hereinafter the plurality of NAND flash memory cell strings are referred to as "cell strings." The cell strings may be spaced apart from each other in first and second directions along top surface of the substrate. The row decoder 240 may select a memory block among the plurality of memory blocks for performing program or read operation on the selected memory block. More particularly, the row decoder 240 may select the memory block among the plurality of memory blocks based on a block address of the address received from the memory controller 16.

The memory cell array 210 may include a plurality of memory cells, and each of the plurality of memory cells may store different number of data bits. For example, each memory cell may be one of a single-level cell (SLC), a multi-level cell (MLC), and a triple-level cell (TLC). The SLC stores one bit of data, the MLC stores two bits of data, and the TLC stores three bits of data. However, the inventive concept is not limited thereto, and the memory cell may for example be a quad-level cell QLC that stores four bits of data.

The plurality of memory blocks may include at least one of a single-level cell block, a multi-level cell block, a triple-level cell block, and a quad-level cell block. The single-level cell block may include SLCs, the multi-level cell block may include MLCs, the triple-level cell block may include TLCs, and the quad-level cell block may include QLCs. A portion of the plurality of memory blocks of the memory cell array 210 may include single-level cell blocks, and the other portion of the plurality of memory blocks may include multi-level cell blocks or triple-level cell blocks.

An erase operation on a memory block of the memory cell array 210 may be performed by applying an erase voltage on the memory block. When the erase operation is completed, the memory cells of the memory block may be in an erased state. Thereafter, a program operation on the memory block of the memory cell array 210 may be performed by receiving a command CMD, an address ADRR and data DATA from the memory controller 16. For the program operation, a word line is selected based on the address ADRR, and a program voltage is applied to the selected word line based on the data DATA. When the program operation is completed, the memory cells on which the program operation being performed may be in a programmed state. The programmed state may be distinguished from the erased state according to a threshold voltage of the programmed memory cells.

The control logic 220 may receive a command CMD, an address ADDR, and a control signal CTRL from the memory controller 16, and generate a row address X-ADDR and a column address Y-ADDR based on the received address. A word line and a bit line may be selected for read or program operation based on the row address X-ADDR and the column address Y-ADDR. The control logic 220 further generate internal control signals for writing data DATA into the memory cell array 210 or reading data DATA from the memory cell array 210 based on the command CMD, the address ADDR, and the control signal CTRL.

The control logic 220 may provide the internal control signals to the voltage generator 230, the row decoder 240, and the page buffer circuit 250. For example, the control logic 220 may provide a voltage control signal CTRL_vol to the voltage generator 230.

The voltage generator 230 may generate a word line voltage VWL and provide the word line voltage VWL to the selected word line. The voltage generator 230 may further generate several different voltages for a program operation, a read operation, and an erase operation on the memory cell array 210 based on the voltage control signal CTRL_vol. The word line voltage VWL may be a program voltage, a pass voltage, a verification voltage, or a read voltage.

According to an embodiment, the voltage generator 230 may generate and provide program voltages and verification voltages based on the voltage control signal CTRL_vol. The program voltages and verification voltages may have different voltage levels at different program loops. The program loops are performed by an incremental step pulse programming (ISPP), in which the program voltages may be increased as the number of program loop increases. For example, the voltage generator 230 may provide a first program voltage having a first voltage level for a first program loop, and provide a second program voltage having a second voltage level for a second program loop. The second voltage level may be higher than the first voltage level when the first and second program voltages are applied for first and second program loops. The verification voltage may be applied to the selected word line after each of the first and second program loops to check whether the program operation for the memory cells on which the program operation being performed are completed in previous program loop or additional program loop is required. The program loops, in which applying program voltage and verification voltage on the selected word line, may be repeated until the programmed memory cells are verified to be in a targeting programmed state.

The voltage generator 230 may generate and provide the program voltage, and the verification voltage to the selected word line selected from among the plurality of word lines WL. The selected word line may include at least one word line selected by a row address X-ADDR which is generated in the row decoder 240 based on the address ADDR.

The row decoder 240 may select a word line among the plurality of word lines WL based on the row address X-ADDR received from the control logic 220. More specifically, in a program operation, the row decoder 240 may provide a program voltage to the selected word line. The selected word line may also be referred to as a target word line. In addition, the row decoder 240 may select a cell string among the plurality of cell strings by applying a string selection voltage on a selected string selection line among the string selection lines SSL and applying a ground selection voltage on a ground selection line among the ground selection lines GSL based on the row address X-ADDR received from the control logic 220.

The page buffer circuit 250 may be connected to the memory cell array 210 through the bit lines BL. The page buffer circuit 250 may select corresponding bit lines among the bit lines BL based on a column address Y-ADDR received from the control logic 220. The page buffer circuit 250 may operate as a sense amplifier to sense the data DATA stored in the memory cell array 210 during the read operation and the program operation. The page buffer circuit 250 may operate as a write driver to drive the data DATA to be stored in the memory cell array 210 during the program operation.

The page buffer circuit 250 may store the data DATA read from the memory cell array 210 or may temporarily store the data DATA to be written into the memory cell array 210. The page buffer circuit 250 may perform a sensing operation to sense a sensing value of the memory cell array 210 based on the verification voltage under the control of the control logic 220. When the verification voltage is applied to the selected word line, the page buffer circuit 250 may temporarily store the sensing value sensed from the memory cell array 210. The stored sensing value may include a count value. The count value may be a number of on-cells among the plurality of memory cells connected to the selected word line.

When the row decoder 240 applies the program voltage to the selected word line in the program operation, the page buffer circuit 250 may apply a bit line voltage, such as a program inhibit voltage and a program voltage, to the bit lines BL according to the speed at which the memory cells are programmed.

The page buffer circuit 250 may include a plurality of page buffers respectively connected to the bit lines BL. The plurality of page buffers may be arranged to be connected to the respective bit lines, wherein each page buffer may include a plurality of latches. Hereinafter, a page buffer circuit may include a page buffer connected to each bit line. However, embodiments are not limited thereto. For example, one page buffer may be connected to a plurality of different bit lines sequentially. The page buffer arranged to be connected to each bit line of the plurality of different bit lines may be defined as a page buffer unit.

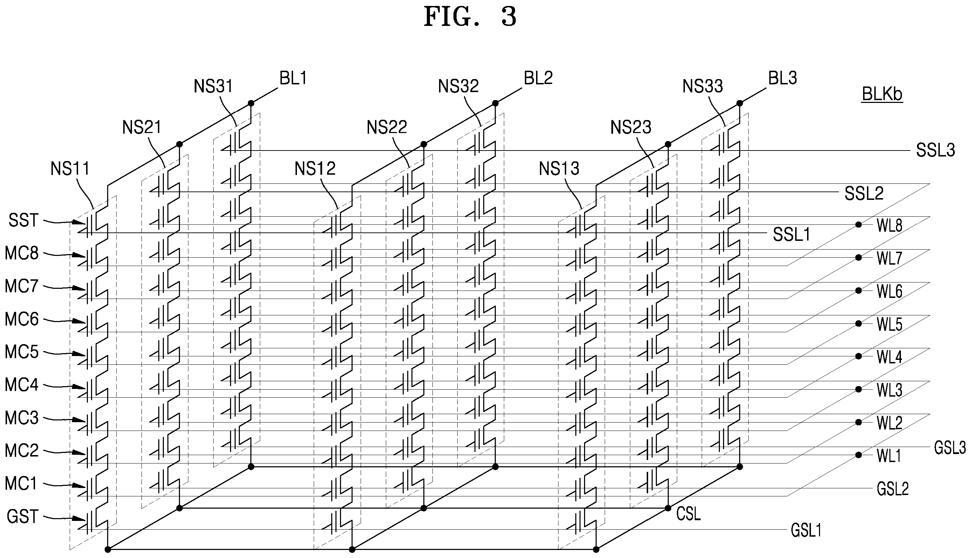

FIG. 3 is a circuit diagram of a memory block BLKb according to an embodiment.

Referring to FIG. 3, the memory block BLKb may include a vertically stacked NAND flash memory cells. For example, the memory block BLKb may include a plurality of NAND strings NS11 to NS33, a plurality of word lines WL1 to WL8, a plurality of bit lines BL1 to BL3, ground selection lines GSL1, GSL2, and GSL3, a plurality of string selection lines SSL1, SSL2, and SSL3, and a common source line CSL. The number of NAND flash memory cell strings, the number of word lines, the number of bit lines, the number of ground selection lines, and the number of string selection lines may be different depending on the size of the memory block BLKb.

The NAND flash memory cell strings NS11, NS21, and NS31 may be disposed between the first bit line BL1 and the common source line CSL, the NAND flash memory cell strings NS12, NS22, and NS32 may be disposed between the second bit line BL2 and the common source line CSL, and the NAND flash memory cell strings NS13, NS23, and NS33 may be disposed between the third bit line BL3 and the common source line CSL. Each NAND flash memory cell string (e.g., NS11) may include a string selection transistor SST, a plurality of memory cells MC1 to MC8, and a ground selection transistor GST connected vertically in series. Hereinafter, the NAND flash memory cell string may be simply referred to as a string.

The NAND flash memory cell strings commonly connected to one bit line constitute one column. For example, the NAND flash memory cell strings NS11, NS21, and NS31 commonly connected to the first bit line BL1 may correspond to a first column, the NAND flash memory cell strings NS12, NS22, and NS32 commonly connected to the second bit line BL2 may correspond to a second column, and the NAND flash memory cell strings NS13, NS23, and NS33 commonly connected to the third bit line BL3 may correspond to a third column.

The NAND flash memory cell strings connected to one string selection line constitute one row. For example, the NAND flash memory cell strings NS11, NS12, and NS13 connected to the first string selection line SSL1 may correspond to a first row, the NAND flash memory cell strings NS21, NS22, and NS23 connected to the second string selection line SSL2 may correspond to a second row, and the NAND flash memory cell strings NS31, NS32, and NS33 connected to the third string selection line SSL3 may correspond to a third row.

The string selection transistor SST is connected to the string selection lines SSL1, SSL2, and SSL3. The plurality of memory cells MC1 to MC8 are respectively connected to the word lines WL1 to WL8. The ground selection transistor GST is connected to the ground selection lines GSL1, GSL2, and GSL3. The string selection transistor SST is connected to the corresponding bit line and the ground selection transistor GST is connected to the common source line CSL.

The word lines (e.g., WL1) in a same stack level may be commonly connected and the string selection lines SSL1, SSL2, and SSL3 in the same stack level may be separately connected to respective string selection transistors. For example, when programming the memory cells of the strings NS11, NS12, and NS13 connected to the first word line WL1 and to the first string selection line SSL1, the first word line WL1 and the first string selection line SSL1 may be selected. As shown in FIG. 3, the ground selection lines GSL1, GSL2, and GSL3 may be separated from each other. Alternatively, the ground selection lines GSL1, GSL2, and GSL3 may be connected to each other.

An erase operation of the NAND flash memory may be performed in a memory block unit. A program operation may be performed in a page unit corresponding to each word line WL1 to WL8. When the memory cell includes an MLC, a TLC, or a QLC, each word line may store data corresponding to multiple pages. For example, when the memory cell includes an MLC, each word line may store data corresponding to a least significant bit (LSB) page and a most significant bit (MSB) page. When the memory cell includes a TLC, each word line may store data corresponding to an LSB page, a center significant bit (CSB) page, and an MSB page.

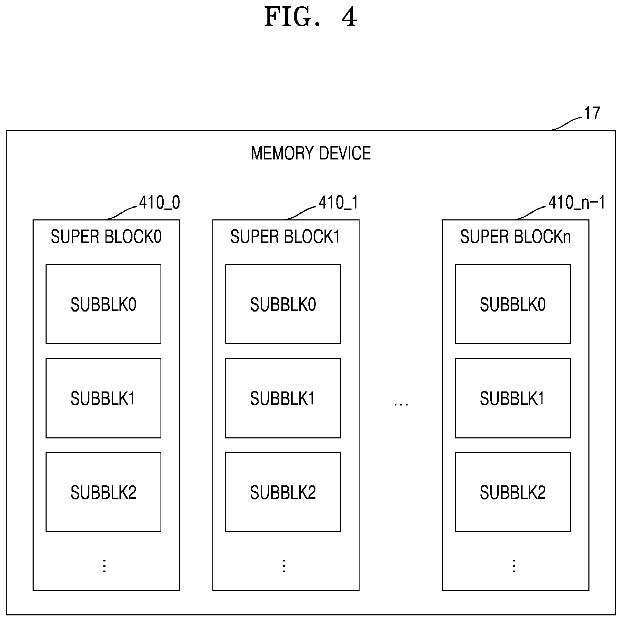

FIG. 4 is a block diagram of a plurality of super blocks 410_0 to 410_n-1 according to an embodiment.

Referring to FIGS. 1 to 4, the memory device 17 may include the plurality of super blocks 410_0 to 410_n-1 operating logically in an interleaving manner. Although n number of super blocks are illustrated in FIG. 4, the super blocks are not limited to the number.

Each of the plurality of super blocks 410_0 to 410_n-1 may include a plurality of sub-memory blocks SUBBLK0, SUBBLK1, SUBBLK2, and the like. The plurality of sub-memory blocks SUBBLK0, SUBBLK1, SUBBLK2, and the like may be included in a non-volatile memory device among the first to mnth non-volatile memory devices NVM11 to NVMmn in FIG. 1.

Although three sub-memory blocks are illustrated in FIG. 4 in each super block, the number of sub-memory blocks may be different in different super blocks. Referring to FIGS. 1, 2, and 4, the plurality of memory blocks included in non-volatile memory devices NVM11, NVM21 to NVMm1 connected to first way of memory device 17 may be the sub-memory blocks of the first super block 410_0. The plurality of memory blocks included in non-volatile memory devices NVM12, NVM22, to NVMm2 may be the sub-memory blocks of the second super block 410_1. Likewise, the plurality of memory blocks included in non-volatile memory devices NVM1n, NVM2n, to NVMmn may be the sub-memory blocks of the n-1th super block 410_n-1. At least part of the plurality of sub-memory blocks SUBBLK0, SUBBLK1, SUBBLK2, and the like may be included in one non-volatile memory device. The non-volatile memory devices including one super block may be referred to as ith non-volatile memory devices, where i is a natural number greater than 0. For example, the non-volatile memory devices NVM11, NVM21 to NVMm1 including the first super block 410_0 may be referred to as first non-volatile memory devices, the non-volatile memory devices NVM12, NVM22, to NVMm2 including the second super block 410_1 may be referred to as second non-volatile memory devices, and the non-volatile memory devices NVM1n, NVM2n, to NVMmn including the n-1th super block 410_n-1 may be referred to as nth non-volatile memory devices. However, the inventive concept is not limited thereto.

According to an embodiment, the memory controller 16 may provide one or more commands and addresses corresponding to each of the selected super blocks (e.g., target super blocks) among the plurality of super blocks 410_0 to 410_n-1. one or more commands and addresses are generated in the memory controller 16 based on requests from a host. For example, the host may sequentially provide a first request and a second request to the memory system 15. The memory controller 16 may provide one or more first commands and first addresses corresponding to the first super block 410_0 to the memory device 17 in response to the first request from the host. Then, the memory controller 16 may provide one or more second commands and second addresses corresponding to the second super block 410_1 to the memory device 17 in response to the second request from the host. The memory controller 16 may provide the one or more first commands and first addresses and the one or more second commands and second addresses sequentially in a scheduled order. For example, the memory controller 16 may provide the one or more second commands and second addresses after providing the one or more first commands and first addresses.

According to an embodiment, in response to a write request from the host, the memory controller 16 may provide program commands and addresses corresponding to target word lines, to the memory device 17. Upon receiving the program commands and addresses, the target word lines may be word lines selected for each of the plurality of sub-memory blocks SUBBLK0, SUBBLK1, SUBBLK2, and the like included in a target super block of the plurality of super blocks 410_0 to 410_n-1. A particular word line may be selected for each of the plurality of sub-memory blocks SUBBLK0, SUBBLK1, SUBBLK2, and the like. The program operation may be performed on the target word line for each of the plurality of sub-memory blocks SUBBLK0, SUBBLK1, SUBBLK2, and the like. The program operations may be simultaneously performed on the target word lines. For example, the program operation may be simultaneously performed on the target word line in the sub-memory block SUBBLK0 of the first super block 410_0, the target word line in the sub-memory block SUBBLK1 of the first super block 410_0, and the target word line in the sub-memory block SUBBLK2 of the first super block 410_0.

According to an embodiment, the memory controller 16 may provide addresses and program commands to the memory device 17 sequentially to program the plurality of word lines WL for each sub-memory block of the target super block in response to a sequential write request from the host. For example, referring to FIGS. 3 and 4, when each sub-memory block includes 8 word lines as shown in FIG. 3, the program operations may be sequentially performed in a descending order from the word line WL8 to the word line WL1 or in an ascending order from the word line WL1 to the word line WL8 for each of the plurality of sub-memory blocks SUBBLK0, SUBBLK1, SUBBLK2, and the like. The program operations for the word line WL8 included in each of the plurality of sub-memory blocks SUBBLK0, SUBBLK1, SUBBLK2, and the like may be performed simultaneously. When the program operation for each target word line is completed, the program operations for the next target word line may be performed.

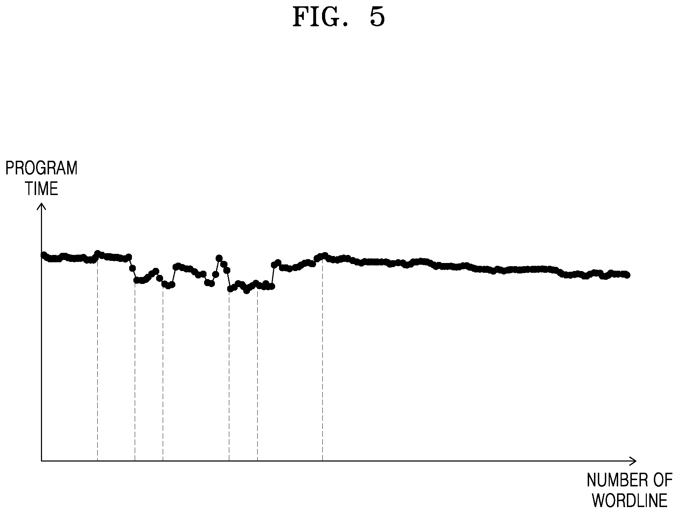

FIG. 5 is an example of program time for word lines according to an embodiment.

Referring to FIG. 5, the program time required for word lines in the same memory block (or the same sub-memory block) of the first to mnth non-volatile memory devices NVM11 to NVMmn may be different form each other due to the process variations of the non-volatile memory device. The program time may be a time measured from the start of the program operation to the end of the program operation. The program time may be as defined as "tPROG" in a standard released by the joint electron device engineering council (JEDEC).

According to an embodiment, a portion of word lines among the plurality of word lines WL may require the program times less than an average program time. The average program time may be an average time required to program each word line of the plurality of word lines WL. A portion of word lines among the plurality of word lines WL may require the program times greater than the average program time. Most of word line among the plurality of word lines WL may require the program times close to the average program time.

According to an embodiment, a portion of word lines among the plurality of word lines WL may require a minimum program time. The minimum program time may be the smallest program time of the program times of the plurality of word lines WL. A portion of word lines among the plurality of word lines WL may require a maximum programming time. The maximum program time may be the greatest program time of the program times of the plurality of word lines WL.

Since the program time is different for each word line, the program times may exhibit a Gaussian distribution across different word lines. In addition, as the number of memory stacks of a memory block increases, the size of the memory block may increase. Therefore, the number of word lines in the memory block may increase, and the range of difference in program times between word lines may also increase. Due to the difference in program time between word lines, the range of the program time fluctuation (or write fluctuation) in the non-volatile memory devices may increase, thereby deteriorating the reliability of data and the performance of the memory system 15.

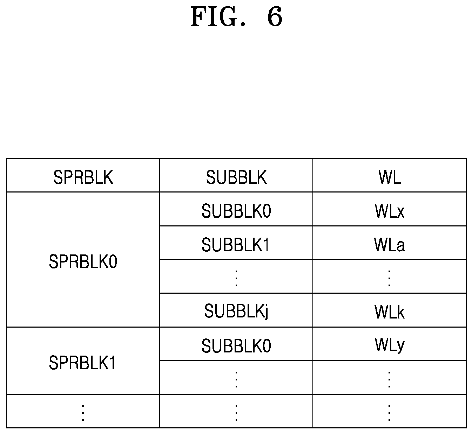

FIG. 6 is a diagram illustrating an example of a word line table according to an embodiment.

Referring to FIG. 6, the word line table included data indicating word lines that require a program time less than a reference program time for each of the plurality of memory blocks. The reference program time may be an average program time for each word line of the plurality of non-volatile memory devices. More particularly, the word line table may include addresses of the word lines, in which the program times for the word lines are less than the average program time (for example, the word line table may include addresses of specific word lines, wherein the program times for the specific word lines are less than the average program time), and/or the word line table may include addresses of the word lines, in which the program times for the word lines are greater than the average program time.

The word line table may include data indicating word lines that require a program time less than the average program time for each of the sub-memory blocks included in each super block.

According to an embodiment, the word line table may include data indicating word lines that require the minimum program time for each of the sub-memory blocks included in each super block.

Referring to FIG. 6, for example, word lines WLx, WLa, and WLk in sub-memory blocks SUBBLK0, SUBBLK1, to SUBBLKj of a first super block SPRBLK0 may require the minimum program time, where j is a natural number greater than 0. A word line WLy in the sub-memory block SUBBLK0 of the second super block SPRBLK1 may require the minimum program time. However, the inventive concept is not limited thereto. The word line table may also include data indicating the word lines that require the minimum program time in other memory blocks of the memory device 17.

According to an embodiment, the word line table may include data indicating the word lines that require the program time less than the average program time for each of the plurality of memory blocks (e.g., the first to zth memory blocks BLK1 to BLKz in FIG. 2). Alternatively, the word line table may include data indicating the word lines that require the minimum program time for each memory block.

At least one non-volatile memory device of the first to mnth non-volatile memory devices NVM11 to NVMmn of the memory system 15 may include the word line table. During a power-up sequence of the memory system 15, the memory controller 16 may load the word line table stored in the non-volatile memory device into an internal memory of the memory system 15 which may be implemented in a static random-access memory (SRAM). The memory controller 16 may control the non-volatile memory device storing the word line table to perform a background operation to update the word line table.

The word line table may be generated during a test phase of the memory system 15. The word line table may be generated and updated in response to the background operation of the memory system 15 periodically based on the request from the host while operating the memory system 15. Alternatively, the word line table may be generated and updated in response to the background operation of the memory system 15 periodically regardless of the request from the host while operating the memory system 15.

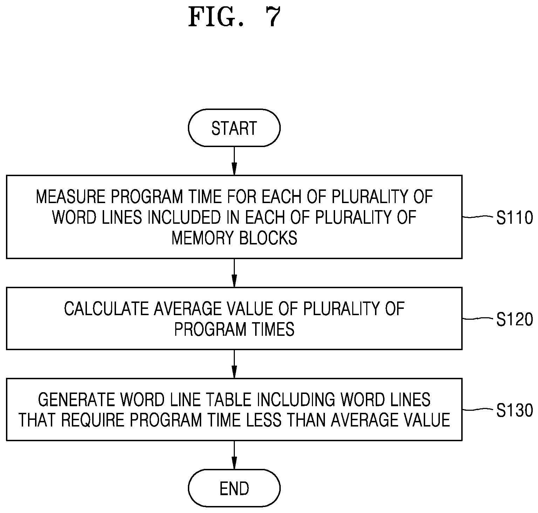

FIG. 7 is a flowchart of generating a word line table according to an embodiment.

Referring to FIG. 7, in step S110, the storage controller may measure a program time for each of a plurality of word lines included in each of a plurality of memory blocks of non-volatile memory devices. For example, the storage controller may measure a program time for the word lines WL included in each of the first to zth memory blocks BLK1 to BLKz. The storage controller may measure the program time by measuring a time period between a first time point at which the program command and the address corresponding to the word line are provided to the corresponding non-volatile memory device and a second time point at which a response from the corresponding non-volatile memory device is received. Alternatively, the storage controller may measure the program time by measuring a time period between the first time point at which the storage controller provides the address and the program command to corresponding non-volatile memory device and the second time point at which the non-volatile memory device returns a response indicating that the program operation is completed. The non-volatile memory device returns the response signal in response to a response request signal from the storage controller. The storage controller may transmit the response request signal periodically, in which the period may be preset by the storage controller. Therefore, the second time point may be a r number of times of the preset period at which the memory device returns the response signal for the rth response request signal. However, the inventive concept is not limited thereto.

In step S120, the storage controller may calculate an average value of the plurality of program times measured in step S110. In addition, the storage controller may set the average value as the reference program time.

In step S130, the storage controller may generate a word line table including data indicating word lines, in which program times required for programming each of the word lines are less than the reference program time. Alternatively, the storage controller may generate the word line table including word lines, in which program times required for programming each of the word lines are minimum program time.

The program time required for most word lines may be close to the reference program time. The storage controller may compare the program time for the currently selected word line with the average program time measured in word lines of the plurality of non-volatile memory devices, may update the data of the word line table to indicate that program time required for the currently selected word line is relatively small compared with the reference program time, and may omit measuring the program time for the word line to be selected after obtaining the data or discard the data indicating word lines requiring a relatively long program time.

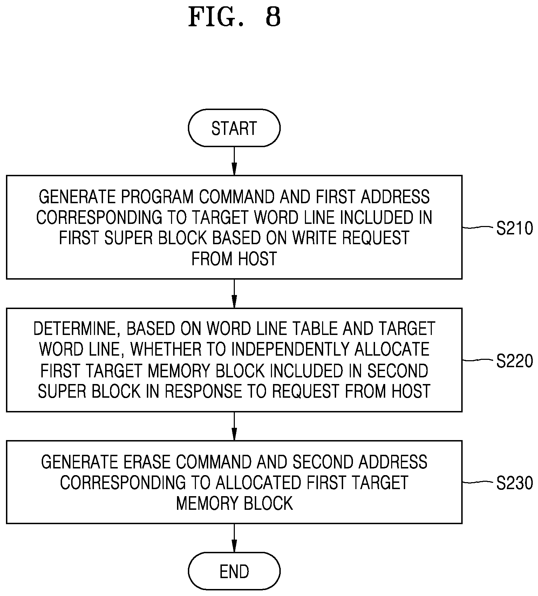

FIG. 8 is a flowchart illustrating an operation of a storage device according to embodiments.

Referring to FIG. 8, in step S210, the storage controller generates a program command and a first address corresponding to a target word line included in a first target non-volatile memory device of non-volatile memory devices of FIG. 1 based on a write request from the host. The first target non-volatile memory device may be included in a super block.

The storage controller may generate first addresses and program commands to perform a program operation in an interleaving manner on a first super block (e.g., the first super block 410_0 in FIG. 4) including a plurality of first non-volatile memory devices (e.g., the non-volatile memory devices NVM11, NVM21 to NVMm1 in FIG. 1), based on the write request from the host.

In step S220, the storage controller determines, based on the word line table and the target word line of the first address and in response to the request from the host, whether to independently allocate the first target memory block included in the second target non-volatile memory device of the non-volatile memory devices for an erase operation.

The word line table includes first data indicating first word lines, in which a first program time required for the first word lines is less than the reference program time required for programming each word line of the memory blocks (e.g., the first to zth memory blocks BLK1 to BLKz in FIG. 2). The word line table may correspond to the word line table shown in FIG. 6.

According to an embodiment, a first super block may include a first target non-volatile memory device while a second super block different from the first super block may include a second target non-volatile memory device. The first target memory block may include an information on a memory block that is pre-assigned to perform the erase operation regardless of whether the request from the host is received. The first target memory block may correspond to one of sub-memory blocks included in one of the super blocks.

The storage controller determines, based on the word line table and the target word lines of the first addresses and in response to the request from the host, whether to independently allocate at least one first target sub-memory block included in a second super block (e.g., the second super block 410_1 of FIG. 4) for performing an erase operation on the first target sub-memory block.

The word line table may include data indicating word lines, in which the program time required for programming each of the word lines is less than the reference program time required for programming each of the plurality of sub-memory blocks (e.g., SUBBLK0, SUBBLK1, SUBBLK2, and the like) included in super blocks (e.g., the plurality of super blocks 410_0, 410_1, to10_n). The word line table may correspond to the word line table shown in FIG. 6.

The first target sub-memory block may correspond to the first target memory block.

In step S230, when the first target memory block is allocated for the erase operation, the storage controller generates an erase command and a second address corresponding to the allocated first target memory block.

When the first target sub-memory block is allocated for the erase operation, the storage controller generates an erase command and a second address corresponding to the allocated first target sub-memory block.

As the size of the memory block increases due to development of fine process technology of non-volatile memory devices, the difference in program time between word lines may be reduced, thereby the non-volatile memory devices of embodiments may maintain consistency in program time and/or write throughput, and device latency and/or performance may be improved.

In addition, because in embodiments the erase operation and the program operation are performed in parallel in different super blocks, the program operation which requires a relatively long program time in one super block may be hidden by the erase operation in another super block which also requires long erase time.

In addition, the erase operation may be distributed to each chip or die. Therefore, in embodiments, the peak power consumed during the erase operation may be reduced while maintaining a constant write throughput, thereby reducing the power required by the device.

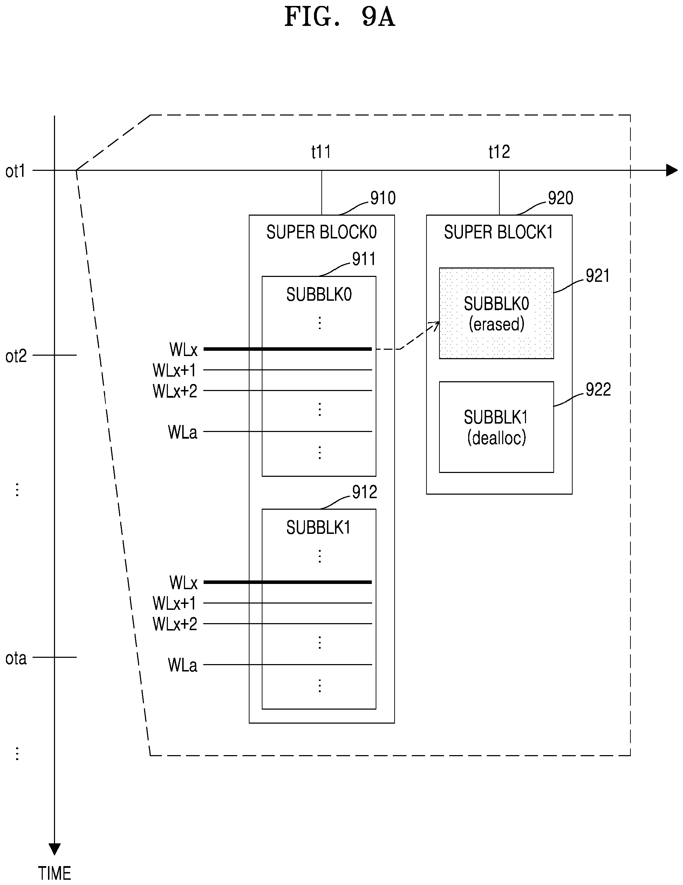

FIGS. 9A to 9C are diagrams illustrating a sequential write operation performed on one super block and an erase operation performed on a sub-memory block of another super block. Although two super blocks and two sub-memory blocks included in each super block are illustrated in FIGS. 9A to 9C, the number of super blocks and the number of sub-memory blocks may not be limited thereto.

Referring to FIGS. 9A to 9C, the host may provide a sequential write request to the storage device. The storage device may perform program operations on word lines sequentially in a preset order for each of a plurality of operation times ot1, ot2, ... , ota, ... based on the sequential write request from the host.

Referring to FIG. 9A, in operation time ot1, the storage controller may generate program commands and first addresses corresponding to the word lines WLx included in each of the first and second sub-memory blocks 911 and 912 of the first super block 910. The first and second sub-memory blocks 911 and 912 may be included in the target non-volatile memory device. Alternatively, the first sub-memory block 911 may be included in one target non-volatile memory device and the second sub-memory block 912 may be included in another target non-volatile memory device. As illustrated in FIG. 6, the word line WLx of the first sub-memory block 911 may include word lines that require the minimum program time. When the word line WLx includes word lines that require the minimum program time, the storage controller may allocate the first sub-memory block 921 of the second super block 920 for an erase operation. The storage controller may generate the erase command and the second address corresponding to the first sub-memory block 921. The storage controller may schedule the first addresses and program commands for performing the program operation in the first sub-memory block 911 of the first super block 910. The storage controller may schedule a second address and an erase command for performing the erase operation in the first sub-memory block 921 of the second super block 920 in a command queue. The storage controller may sequentially output the first addresses and program commands and the second address and the erase command sequentially in a scheduled order. For example, the first addresses and program commands may be output at a first time t11 of the operation time ot1 and the second address and the erase command may be output at a second time t12 of the operation time ot1. However, the inventive concept is not limited thereto. The second address and the erase command may be output at the first time t11 of the operation time ot1 and the first addresses and the program commands may be output at the second time t12 of the operation time ot1. The program operations for the word line WLx may start at the first time t11 of the operation time ot1, and the erase operation for the first sub-memory block 921 may start at the second time t12 of the operation time ot1. The program operation period and the erase operation period may be overlapped at least partially. The second sub-memory block 922 of the second super block 920 may not be allocated or may be deallocated during the second time t12 of the operation time ot1.

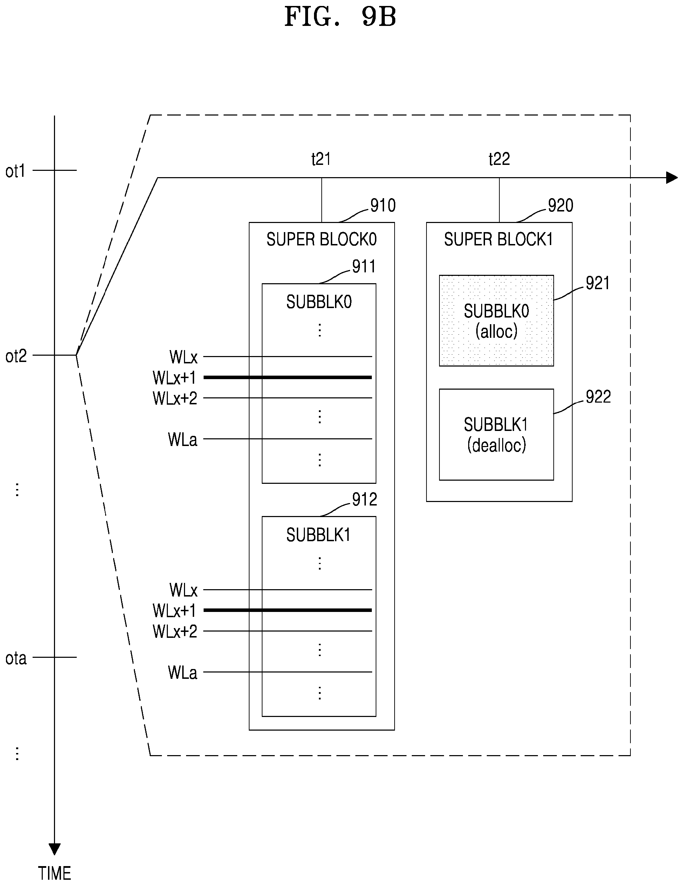

Referring to FIG. 9B, at operation time ot2, the storage controller may generate the program commands and first addresses corresponding to the word lines WLx+1 included in the first and second sub-memory blocks 911 and 912 of the first super block 910. The word lines WLx+1 may include a word line to be programmed after the word line WLx. The program time required for programming each of the word lines WLx+1, for example, may be a reference program time which is an average program time required for programming each of the word lines of the non-volatile memory device. The storage controller may generate the program commands and the first addresses corresponding to the word lines WLx+1. At operation time ot2, the erase operation for the first sub-memory block 921 of the second super block 920 is considered to be completed. When the host provides a request to perform a write operation to the storage device, the storage controller may allocate the first sub-memory block 921 in response to the request and may generate the second address and the operation command based on the request from the host for performing an operation on the first sub-memory block 921 in response to the request. The second address may correspond to the allocated first sub-memory block 921. The generated second address and operation command may be scheduled in the command queue of the storage controller. The first address and the program command may be output at the first time t21 of the operation time ot2 and the program operation for the word lines WLx+1 may start. The second address and the operation command may be output at the second time t22 of the operation time ot2, and the operation on the allocated first sub-memory block 921 may be performed. The operation may include read operation, program operation, and the like.

The program operations may be performed on word lines WLx+2 following the word lines WLx+1 included in the first and second sub-memory blocks 911 and 912 of the first super block 910. The storage device may receive the request from the host and perform the operation in response to the request from the host on the second super block 920.

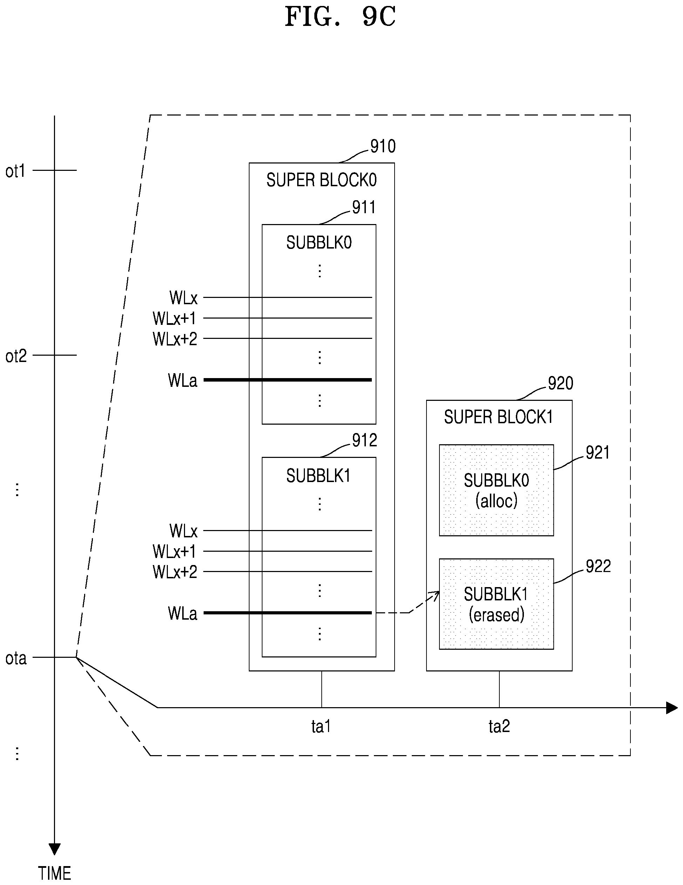

Referring to FIG. 9C, the storage controller controls the non-volatile memory devices to perform operations at the operation time ota after performing the operations at times ot1 and ot2. At the operation time ota, the storage controller may generate the program command and first address corresponding to the word line WLa included in each of the first and second sub-memory blocks 911 and 912 of the first super block 910. As illustrated in FIG. 6, when the word line WLa of the second sub-memory block 912 includes word lines that require the minimum program time, the storage controller may allocate the second sub-memory block 922 of the second super block 920 and may generate the erase command and the second address corresponding to the second sub-memory block 922. The program operations for the word line WLa may start at a first time ta1 of the operation time ota and the erase operation for the second sub-memory block 922 may start at a second time ta2 of the operation time ota. the program operations performed on the first and second sub-memory blocks 911 and 912 of the first super block 910 and the erase operation performed on the second sub-memory block 922 of the second super block 920 may be overlapped at least partially.

Each time the target word lines according to the first addresses correspond to word lines indicated by the first data of the word line table, the sub-memory block of the second super block may be allocated one by one. Referring to FIG. 9A, for example, when the word line WLx included in the first sub-memory block 911 of the first super block 910 is selected as the target word line, the first sub-memory block 921 of the second super block 920 may be allocated. When the word line WLa included in the second sub-memory block 912 of the first super block 910 is selected as the target word line, the second sub-memory block 922 of the second super block 920 may be allocated. When two or more word lines of the first super block 910 are indicated by the first data of the word line table, two or more sub-memory blocks of the second super block 920 may be allocated.

After the erase operation for the second sub-memory block 922 of the second super block 920 being completed, the program operation in the first super block 910 may be performed sequentially on the word lines following the word line WLa. When the subsequent word lines are different from the word lines indicated by the first data of the word line table (for example, when the target word lines are different from the first word lines), an operation command and at least one third address corresponding to at least one sub-memory block of the second super block 920 may be generated and output in response to the request from the host.

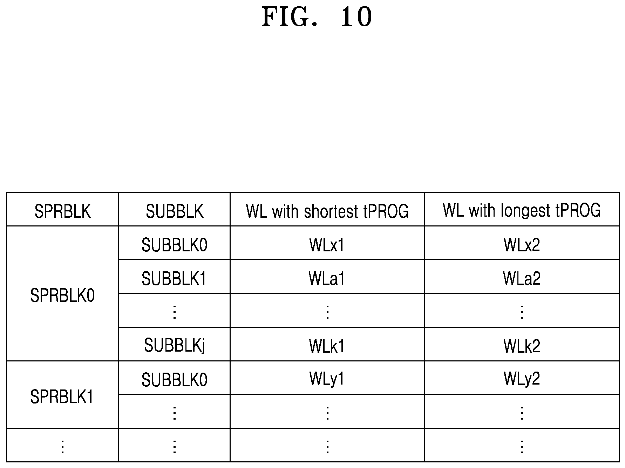

FIG. 10 is a diagram illustrating an example of a word line table according to an embodiment.

Referring to FIG. 10, the word line table may include first data indicating first word lines, in which the program time required for programming each of the first word lines is less than the reference program time required for programming each word line of the plurality of memory blocks. In addition, the word line table may further include second data indicating second word lines, in which the program time required for programming the second word line is greater than the reference program time.

The word line table may include the first data and the second data for each of the sub-memory blocks included in each super block, in which the first data may indicate first word lines in which a program time required for programming each of the first word lines is less than the average program time, and the second data may indicate second word lines in which a program time required for programming each of the second word lines is greater than the average program time.

Alternatively, the word line table may include the first and second data, in which the first data indicates first word lines in which a program time required for programming each of the first word lines indicated by the first data is the minimum program time of each block, and the second data indicates second word lines in which that a program time required for programming each of the second word lines indicated by the second data is the maximum program time of each block.

Referring to FIG. 10, the word line table may include the first data indicating first word lines in which a program time required for programming each of the first word lines may be the minimum program time. For example, the word line table of FIG. 10 illustrates that the first data may indicate word lines WLx1, WLa1, WLk1, and WLy1. The word line table may include the second data that indicates second word lines in which a program time required for programming each the second word lines may be the maximum program time. For example, the word line table of FIG. 10 illustrates that the second data may indicate word lines WLx2, WLa2, WLk2, and WLy2. However, the inventive concept is not limited thereto. The word line table may include the first and second data indicating the first and second word lines in which a first program time required for programming each of the first word lines may be the minimum program time and a second program time required for programming each of the second word lines may be the maximum program time respectively.

The word line table may include, for each memory block, a first data indicating first word lines in which a program time required for programming each of the first word lines is less than the average program time, and a second data indicating second word lines in which a program time required for programming each of the second word lines may be greater than the average program time. Alternatively, the word line table may include first and second data indicating first and second word lines in which a first program time required for programming each of the first word lines may be the minimum program time and a second program time required for programming each of the second word lines may be the maximum program time respectively.

The storage controller may measure the program time for each word line and may generate the word line table of FIG. 10 based on the measured program times.

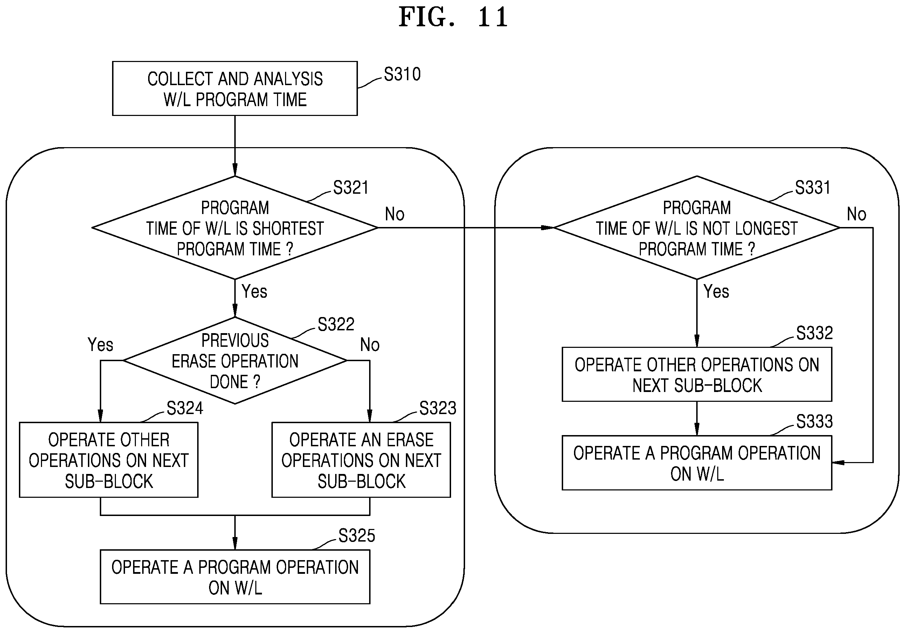

FIG. 11 is a flowchart of an operation of a storage device according to embodiments.

Referring to FIG. 11, in step S310, the storage controller may collect and analyze data of the program time for each word line. The operation in step S310 may correspond to a step of generating the word line table shown in FIG. 7.

In step S321, the storage controller may determine whether the at least one currently selected target word line is indicated by the data of the word line table. Upon determining that at least one currently selected target word line is indicated by the data of the word line table, the storage controller may determine that the program time of at least one currently selected target word line is shortest of the memory blocks.

When the storage controller determines that the program time of the at least one currently selected target word line is the shortest step S321, an operation in step S322 is followed. The storage controller may allocate a second sub-block of a second super block and may determine whether the erase operation has been completed for the second sub-block. The current sub-block may be included in a super block (e.g., the first super block 910), the second sub-block may be included in another super block (e.g., the second super block 920). The operation in step S322 may correspond to the operation of an embodiment shown in FIGS. 9A to 9C.

Upon determining in the step S322 that the erase operation has not been previously performed on the second sub-block, the storage controller may perform step S323, in which the storage controller may control the non-volatile memory device to perform the erase operation on the second sub-block.

Upon determining in the step S322 that the erase operation has been previously completed for the second sub-block, the storage controller may perform step S324, in which the storage controller may generate the second address and the operation command to perform operations other than an erase operation on the second sub-block based on the request from the host. The operations performed on the second sub-block may include, for example, a read operation.

In step S325, the storage controller may generate the first address and the program command to perform the program operation on the target word line of the current sub-block based on the write request from the host.

the first address and the program command may be scheduled in an order, in which the storage controller execute the program operation, the erase operation, and other operations in steps S323, S324, and S325 based on the scheduled order.

Upon determining in step S321 that the program time of the at least one currently selected target word line is not the shortest, the storage controller may perform step S331, in which the storage controller may determine whether the program time of the at least one currently selected target word line is not the longest. For example, the storage controller determines whether the at least one target word line may be different from the word lines indicated by the data of the word line table.

Upon determining in step S331 that the program time of the at least one currently selected target word line is not the longest, the storage controller may perform step S332, in which the storage controller may generate the operation command and the third address corresponding to the second target memory block included in the second target non-volatile memory device to perform operations other than an erase operation on the second sub-block in response to the request from the host. Thereafter, the storage controller may sequentially output the third address and the operation command and the first address and the program command according to the scheduled order. For example, when the target word line is different from each of the first word line and the second word line, the storage controller may sequentially provide the commands and addresses in a scheduled order to the first and second target non-volatile memory devices. The operations performed on the second sub-block may include a read operation, an external read operation, and the like.

Upon determining in step S331 that the program time of the at least one currently selected target word line is the longest, the storage controller may perform step S333, in which the storage controller may hold the output of the third address and the operation command to prevent performing the operation on the second sub-block. For example, when the target word line is different from the first word line and same as the second word line, the storage controller may hold providing the command and address to the second target non-volatile memory device. Then, the storage controller may generate and output the first address and the program command to perform the program operation on the target word line of the current sub-block based on the write request from the host. The storage controller may perform operations including a get feature command, a set feature command, a get feature universal internal bus (UIB), a set feature UIB, and the like.

According to embodiments, The program operation is performed in parallel with an erase operation in different sub-block when the program times required for programming each of the word lines are relatively small compared with reference program time required programming each of word lines of the non-volatile memory device. The program operation performed on the word lines, in which program times required for programming each of the word lines are relatively long compared with the reference program time, may maintain the uniform throughput and latency, because the long latency of the write operation may be reduced by performing the write operation without erase operation in other sub-block. Accordingly, the performance of the memory device may be improved.

In addition, the erase operation units may be distributed across the non-volatile memory devices without overlapping of erase sections by performing the erase operation one after another in different sub-blocks. Therefore, write time consistency may be preserved and power consumption may be optimized. Accordingly, device reliability may be improved and power consumption may be reduced.

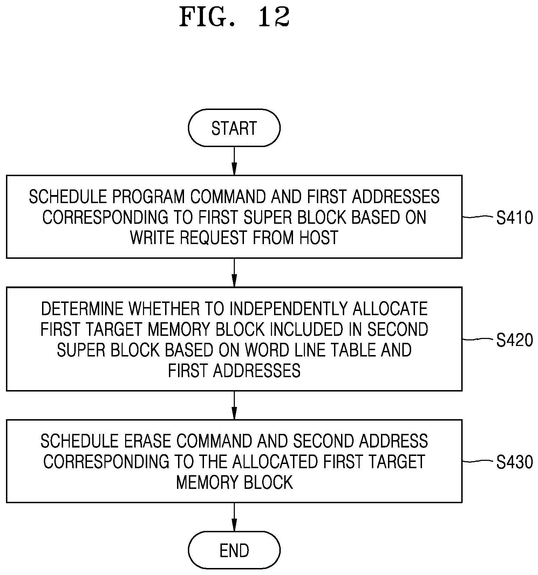

FIG. 12 is a flowchart illustrating an operating method of a storage device according to an embodiment.

Referring to FIG. 12, in step S410, the storage controller may schedule an order of providing the program command and the first address corresponding to the target word line included in the first super block based on the write request from the host.

In step S420, the storage controller may determine, based on the word line table and the first address of the target word line, whether to independently allocate the first target memory block included in the second super block. The word line table may include data indicating word lines, in which the program time required for programming each of the word lines is less than the reference program time.

In step S420, the storage controller may further determine whether the target word line is indicated by the data of the word line table. Upon determining that the target word line is indicated by the data of the word line table, the storage controller may allocate the first target memory block based on the target word line indicated by the data of the word line table. Upon determining that the target word line is not indicated by the data of the word line table, the storage controller may allocate the second target memory block included in the second super block in response to the request from the host based on the target word line.

In step S430, the storage controller may schedule the erase command and the second address corresponding to the allocated first target memory block for an erase operation. For example, when the target word line is same as the first word line, the storage controller may allocate the first target memory block for performing the erase operation on the first target memory block.

The program operation according to the program command and the erase operation according to the erase command may be overlapped at least partially.

The operating method of the storage device may further include providing the first address and the program command, and the second address and the erase command (for example, to the first target memory block (for example, the first target non-volatile memory device) and the second target memory block (for example, the second target non-volatile memory device) respectively) in the scheduled order.

The operating method of the storage device may further include updating the word line table in response to an update request from the host or updating the word line table through a periodic background operation.

The updating of the word line table may include measuring a plurality of program times of the plurality of word lines, setting an average value of the plurality of program times as a reference program time, and generating the word line table including data indicating that program times required for programming each of the word lines are less than the reference program time.

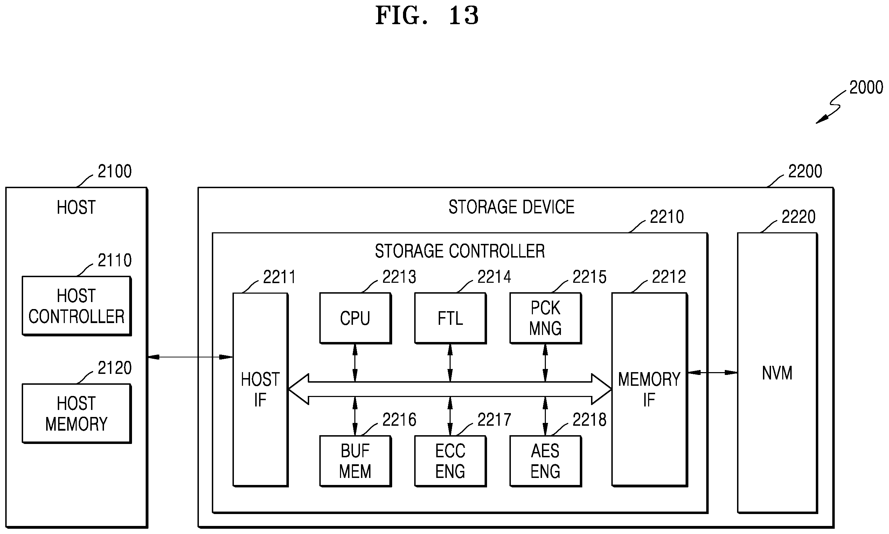

FIG. 13 is a block diagram of a host-storage system 2000 according to an embodiment.

Referring to FIG. 13, the host-storage system 2000 may include a host 2100 and a storage device 2200.

The host 2100 may include a host controller 2110 and a host memory 2120.

The host controller 2110 may manage the operation of storing data (e.g., write data) in a non-volatile memory (NVM) device 2220 or storing data (e.g., read data) of the NVM 2220 in a buffer area.

The host memory 2120 may function as a buffer memory for temporarily storing data to be transmitted to the storage device 2200 or data transmitted from the storage device 2200.

The storage device 2200 may include storage media for storing data in response to the request from the host 2100. The storage device 2200 may include at least one of an SSD, an embedded memory, and a removable external memory.

The storage device 2200 may include a storage controller 2210 and the NVM 2220.

The storage controller 2210 may include a host interface 2211, a memory interface 2212, a central processing unit (CPU) 2213, a flash translation layer (FTL) 2214, a packet manager 2215, a buffer memory 2216, an error correction code (ECC) engine 2217, and an advanced encryption standard (AES) engine 2218.

Embodiments according to present inventive concept may be applied to the storage controller 2210.

The host interface 2211 may transmit and receive a packet to and from the host 2100. The packet transmitted to the host interface 2211 may include a command or data to be written to the NVM 2220. The packet transmitted to the host 2100 may include a response to the command or data read from the NVM 2220.

The memory interface 2212 may transmit data to be written to the NVM 2220 or receive data read from the NVM 2220.

The CPU 2213 may control data writing and reading operations on the NVM 2220 by executing the FTL 2214.

The FTL 2214 may perform various functions, such as address mapping, wear-leveling, and garbage collection.

The packet manager 2215 may generate a packet according to the protocol of the interface negotiated with the host 2100 or parse various types of information from the packet received from the host 2100.

The buffer memory 2216 may temporarily store data to be written to or read from the NVM 2220.

The ECC engine 2217 may perform error detection and correction functions on read data read from the NVM 2220.

The AES engine 2218 may perform at least one of encryption and decryption operations on the data input to the storage controller 2210 by using a symmetric-key algorithm.

The number of NVMs 2220 may be one or more depending on applications. The two or more NVMs 2220 may communicate with the memory interface 2212 through a plurality of channels, as described above with reference to FIG. 1. The two or more NVMs 2220 may constitute one or more super blocks.

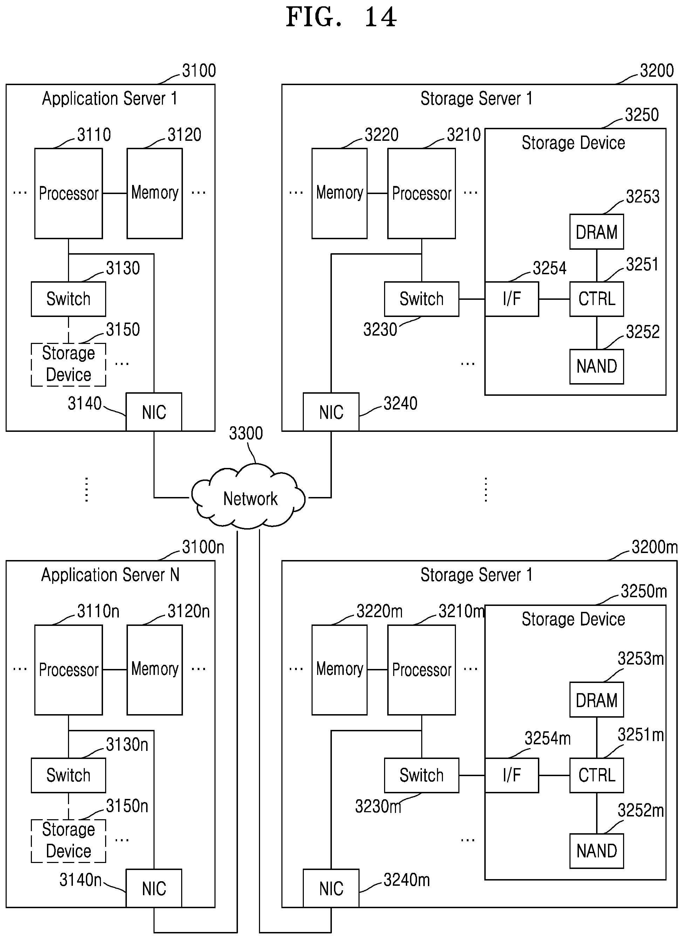

FIG. 14 is a diagram of a data center 3000 to which a memory device is applied, according to an embodiment.

Referring to FIG. 14, the data center 3000 collects various data and provides services. The data center 3000 may also be referred to as a data storage center. The data center 3000 may include a computing system for operating a search engine and database. The data center 3000 may include application servers 3100 to 3100n and storage servers 3200 to 3200m.

The application server 3100 may include a processor 3110 and a memory 3120, and the storage server 3200 may include a processor 3210 and a memory device 3220. For example, application servers 3100 to 3100n may include processors 3110 to 3110n, NICs 3140 to 3140n, and switches 3130 to 3130n, respectively, and storage servers 3200 to 3200m may include processors 3210 to 3210m, NICs 3240 to 3240m, and switches 3230 to 3230m respectively. The processor 3210 of the storage server 3200 may control the overall operation of the storage server 3200 and may access the memory device 3220 to execute instructions and/or data loaded into the memory device 3220. The operation of the storage server 3200 may be similar to the operation of the application server 3100. According to an embodiment, the application server 3100 may not include the storage device 3150. The storage server 3200 may include at least one or more storage devices 3250.

The application servers 3100 to 3100n and the storage servers 3200 to 3200m may communicate with each other through the network 3300. Depending on the access method of the network 3300, the storage servers 3200 to 3200m may be provided as file storage, block storage, or object storage.

Hereinafter, the application server 3100 and the storage server 3200 may be mainly described. The description of the application server 3100 may also be applied to another application server 3100n and the description of the storage server 3200 may also be applied to another storage server 3200m.

The application server 3100 may store the data requested by the user or the client in one of the storage servers 3200 to 3200 m through the network 3300. In addition, the application server 3100 may read out the data requested by the user or the client from one of the storage servers 3200 to 3200m through the network 3300.

The application server 3100 may access the memory 3120n or the storage device 3150n included in another application server 3100n through the network 3300 or may access the memory devices 3220 to 3220m or the storage devices 3250 to 3250m included in the storage servers 3200 to 3200m through the network 3400. The application server 3100 may perform various operations on the data stored in the application servers 3100 to 3100n and/or the storage servers 3200 to 3200m.

The interface 3254 of the storage server 3200 may provide a physical connection between the processor 3210 and the controller 3251 and a physical connection between a network interface controller (NIC) 3240 and the controller 3251.

The storage server 3200 may further include a switch 3230 and the NIC 3240. The switch 3230 may selectively connect the processor 3210 to the storage device 3250 or may selectively connect the NIC 3240 to the storage device 3250 under the control of the processor 3210.

The storage devices 3150 to 3150m and 3250 to 3250n may perform operations according to embodiments described above with reference to FIGS. 1 to 13. The storage devices 3150 to 3150m and 3250 to 3250m may include the controllers 3251 to 3251n and 3251 to 3251m, NAND flash memory devices 3252 to 3252n and 3252 to 3252m, dynamic random-access memories (DRAM) 3253 to 3253n and 3253 to 3253m, and interfaces (I/F) 3254 to 3254n and 3254 to 3254m. The controller 3251 may include SRAM. The storage devices 3250 to 3250m may include a secure element (SE) for security or privacy.

While embodiments has been described , it will be understood that various changes in form and details may be made therein without departing from the scope of the following claims.

## Claims

1. A storage system (15), comprising:
a plurality of non-volatile memory devices (NVM11 - NVMmn), each non-volatile memory device (NVM11 - NVMmn) including a plurality of memory blocks (BLK1 - BLKz); and
a storage controller (16) configured to provide a command (CMDa - CMDm) and an address (ADDRa - ADDRm) to a target non-volatile memory device of the plurality of non-volatile memory devices (NVM11 - NVMmn),
wherein the storage controller (16) is configured to:
receive a write request from a host (2100);
generate a program command and a first address based on the write request from the host (2100), wherein the first address corresponds to a target word line of a first target non-volatile memory device;
determine, based on a word line table and the target word line of the first address, whether to allocate a first target memory block of a second target non-volatile memory device regardless of a request from the host (2100), wherein the word line table comprises first data indicating a first word line that has a program time, which is for programming the first word line, less than a reference program time for word lines (WL) of the plurality of memory blocks (BLK1 - BLKz); and
upon determining to allocate the first target memory block, generate an erase command and a second address, wherein the second address corresponds to the first target memory block.

2. The storage system of claim 1, wherein the storage controller (16) is further configured to:
schedule the program command and the first address;
schedule the erase command and the second address; and
output the program command and the first address and the erase command and the second address, respectively in a scheduled order.

3. The storage system of claim 1 or 2, wherein, when the erase operation for the first target memory block is completed, the storage controller (16) is further configured to generate an operation command and the second address based on the request from the host (2100).

4. The storage system of any preceding claim, wherein the storage controller (16) is further configured to:
allocate the first target memory block for performing the erase operation on the first target memory block when the target word line is same as the first word line; and
generate an operation command and a third address in response to the request from the host (2100) when the target word line is different from the first word line, wherein the third address corresponds to a second target memory block included in the second target non-volatile memory device.

5. The storage system of claim 4, wherein the word line table further comprises second data indicating a second word line that has a program time, which is for programming a second word line, greater than the reference program time, and
wherein the storage controller (16) is further configured to:
hold outputting the operation command and the third address when the target word line is different from the first word line and same as the second word line; and
sequentially output the operation command and the third address and the program command and the first address in a scheduled order when the target word line is different from each of the first word line and the second word line.

6. The storage system of any preceding claim, wherein the storage controller (16) is further configured to:
measure a plurality of program times for a plurality of word lines of the plurality of memory blocks (BLK1 - BLKz);
set an average value of the plurality of program times as the reference program time; and
store data respectively indicating word lines (WL) in the word line table, wherein program times of each of the indicated word lines (WL) are less than the reference program time set as the average value.

7. The storage system of any preceding claim, wherein the storage controller (16) is further configured to:
generate program commands and first addresses corresponding to a plurality of word lines (WL) included in the first target non-volatile memory device based on a sequential write request from the host (2100); and
upon each time detecting that each of target word lines corresponding to the first addresses corresponds the first word line, allocate memory blocks (BLK1 - BLKz) included in the second target non-volatile memory device one by one.

8. The storage system of any preceding claim, wherein the plurality of non-volatile memory devices (NVM11 - NVMmn) comprise:
a plurality of first non-volatile memory devices (NVM11 - NVMm1) comprising a first super block (410_0); and
a plurality of second non-volatile memory devices (NVM12 - NVMm2) including a second super block (410_1),
wherein the first super block (410_0) and the second super block (410_1) operate in an interleaving manner, and
wherein the first target non-volatile memory device comprises the plurality of first non-volatile memory devices (NVM11 - NVMm1), and the second target non-volatile memory device comprises the plurality of second non-volatile memory devices (NVM12 - NVMm2).

9. The storage system of any preceding claim, wherein the storage controller (16) is configured to control at least one non-volatile memory device among the plurality of non-volatile memory devices (NVM11 - NVMmn) to store the word line table.

10. An operating method of a storage system, the operating method comprising:
generating a program command and a first address based on a write request from a host (2100), wherein the first address corresponds to a target word line included in a first super block (410_0);
determining, based on a word line table and the target word line of the first address, whether to allocate a first target memory block included in a second super block (410_1), wherein the word line table comprises data indicating word lines (WL) each having aprogram time less than a reference program time;
generating a second address corresponding to the first target memory block and an erase command; and
scheduling the program command and the first address and the erase command and the second address in a scheduled order, and
wherein the first super block (410_0) and the second super block (410_1) operate in an interleaving manner.

11. The operating method of claim 10, wherein the determining whether to allocate the first target memory block comprises:
determining whether the data of the word line table indicate the target word line;
upon determining that the data of the word line table indicate the target word line, allocating the first target memory block; and
upon determining that the data of the word line table are not indicating the target word line, allocating a second target memory block included in the second super block (410_1) in response to a request from the host (2100).

12. The operating method of claim 10 or 11, further comprising outputting the first address and the program command and the second address and the erase command in a scheduled order.

13. The operating method of any one of claims 10 to 12, wherein a program operation according to the program command and an erase operation according to the erase command are overlapped at least partially.

14. The operating method of any one of claims 10 to 13, wherein the operating method further comprises updating the word line table, in response to an update request from the host (2100) or while performing a background operation.

15. The operating method of claim 14, wherein the updating of the word line table comprises:
measuring a plurality of program times of a plurality of word lines (WL);
setting an average value of the plurality of program times as the reference program time; and
updating data of the word line table by storing data respectively indicating word lines (WL) in the word line table, wherein program times of each of the indicated word lines (WL) are less than the reference program time set as the average value.
